# DEMANDE DE BREVET EUROPEEN

(11) **EP 0 549 463 A1**
(43) Date de publication de la demande: **30.06.1993**
(21) Numéro de dépôt: 92403521.5
(22) Date de dépôt: 22.12.1992
(51) Int. Cl.: G01R 33/035, F17C 13/00

(54) **Dispositif cryogénique pour capteur magnétique**

(30) Priorité: 24.12.1991 FR 9116106
(71) Demandeur: COMMISSARIAT A L'ENERGIE ATOMIQUE, F-75015 Paris (FR)
(72) Inventeur: Locatelli, Marcel, F-38330 Saint-Ismier (FR)
(74) Mandataire: Dubois-Chabert, Guy

(57) **Abrégé**

La présente invention concerne un dispositif cryogénique pour capteur magnétique.

Le but de l'invention est d'améliorer l'isolation thermique de ce dispositif.

Ce but est atteint à l'aide d'un dispositif comprenant une enceinte définie par des parois (11) dites parois chaudes à l'intérieur de laquelle sont disposés un capteur (14) et un réservoir de liquide cryogénique, ce capteur (14) étant entouré de parois refroidies par le liquide cryogénique, dites parois froides (15) et présentant une extrémité avant (16) de mesure placée en vis-à-vis d'une des parois chaudes de l'enceinte formant une paroi chaude de mesure (13), caractérisé en ce que la paroi chaude de mesure (13) est munie de moyens de déplacement.

Ce dispositif concerne plus particulièrement les interféromètres quantiques supraconducteurs.

## Description

La présente invention concerne un dispositif cryogénique pour capteur magnétique. Les capteurs magnétiques à base de supraconducteurs sont utilisés notamment en biomagnétisme, par exemple dans un interféromètre quantique supraconducteur, connu sous l'abréviation anglaise de SQUID "Superconducting Quantum Interference Device". Les supraconducteurs fonctionnent par définition à basse température puisqu'on ne connaît pas de supraconducteurs fonctionnant au-dessus de 23 Kelvin, c'est-à-dire -250°C. Le champ d'application des SQUID s'étend de jour en jour. En effet, ces dispositifs offrent la possibilité de détecter des champs magnétiques extrêmement faibles auxquels nul autre magnétomètre n'est sensible. Ces SQUID sont aujourd'hui utilisés principalement dans le domaine de la médecine où ils permettent de détecter les champs magnétiques issus du corps humain. Ces champs magnétiques peuvent être engendrés soit par les battements du coeur, par le cerveau ou par d'autres organes, mais sont toutefois extrêmement faibles. Il n'était donc pas possible de les mesurer avant la découverte des SQUID.

Par ailleurs, ces dispositifs de mesure sont largement utilisés dans des laboratoires de recherche où ils permettent de mesurer les courants, les tensions et les flux magnétiques.

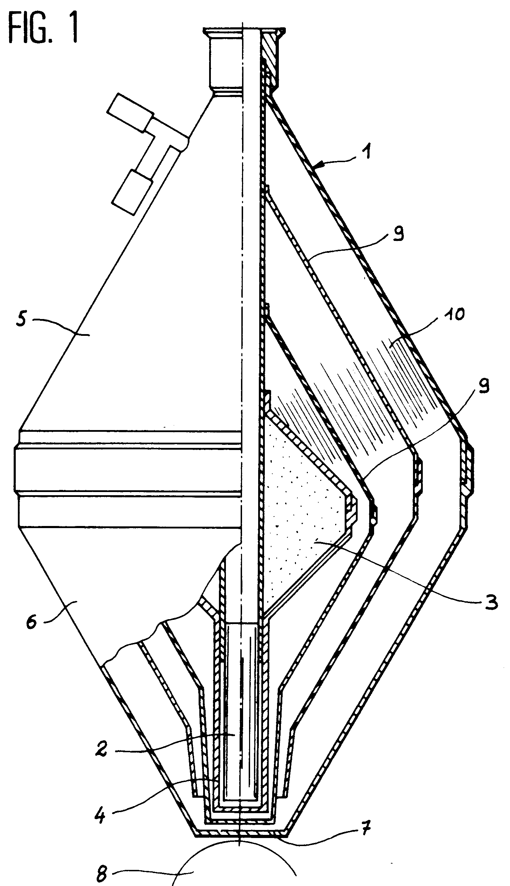

L'un de ces dispositifs connus de l'art antérieur est illustré en figure 1 jointe. Il comprend une enceinte 1 également nommée paroi chaude, à l'intérieur de laquelle sont disposés un capteur magnétique 2 ainsi qu'un réservoir 3 de liquide cryogénique destiné à refroidir ce capteur. Ce liquide cryogénique est par exemple de l'hélium liquide. Le capteur magnétique 2 présente généralement une forme allongée. Dans le mode de réalisation illustré en figure 1, ce capteur est cylindrique. Il est entouré d'une paroi 4 refroidie par le liquide cryogénique et se trouvant en conséquence, à une température d'environ 4,2 K (-269°C). Cette paroi 4 est dite paroi froide. L'enceinte 1 comprend deux moitiés 5, 6 ayant sensiblement une forme tronconique et assemblables l'une avec l'autre par leur extrémité de plus grand diamètre. La moitié 6 (moitié inférieure par rapport à la figure 1) présente une extrémité 7 de petit diamètre, dite surface de mesure de la paroi chaude, puisqu'elle est destinée à venir au contact du corps humain 8 (symbolisé par le sommet d'une tête en figure 1) et sur lequel doivent être effectuées les mesures. La paroi chaude 1 et notamment sa surface de mesure 7 se trouvent à une température voisine de 300 K (27°C), c'est-à-dire proche de la température ambiante.

Lors des mesures, le corps humain 8 est placé au contact de cette surface de mesure 7. Afin de pouvoir effectuer des mesures aussi précises que possible, il est donc nécessaire que le capteur 2 et la paroi froide 4 soient placés au voisinage de la surface de mesure 7 de la paroi chaude. Il en résulte des problèmes importants d'isolation thermique et une grande consommation de liquide cryogénique pour refroidir en permanence la paroi froide 4. Il faut donc remplir fréquemment le réservoir 3 en liquide cryogénique et cet appareil possède une autonomie faible.

On a essayé dans l'art antérieur de résoudre ce problème d'isolation d'une part en utilisant un capteur 2 de forme allongée dont seule l'une des extrémités est placée au contact de la surface de mesure 7 de superficie réduite, et d'autre part, en plaçant entre la paroi chaude 1 et la paroi froide 4, des écrans thermiques 9 et des couches d'isolant 10. Malgré cela, l'isolation thermique n'est que très moyennement assurée.

L'invention a pour but de remédier aux inconvénients précédemment cités.

L'invention concerne un dispositif cryogénique pour capteur magnétique comprenant une enceinte définie par des parois, dites parois chaudes, à l'intérieur de laquelle sont disposés ledit capteur et un réservoir de liquide cryogénique, ce capteur étant entouré de parois refroidies par le liquide cryogénique, dites parois froides et présentant une extrémité avant de mesure placée en vis-à-vis d'une des parois chaudes de l'enceinte formant une paroi chaude de mesure, des moyens d'isolation étant prévus entre lesdites parois froides et lesdites parois chaudes.

Selon les caractéristiques de l'invention, la paroi chaude de mesure est munie de moyens de déplacement permettant de la déplacer entre une position de mesure dans laquelle elle est proche de l'extrémité avant de mesure du capteur et de la paroi froide avant disposée en regard de cette extrémité et une position de repos dans laquelle elle est éloignée de cette paroi froide.

Ainsi, grâce aux caractéristiques de l'invention, la consommation de liquide cryogénique est fortement réduite, puisque le dispositif ne se trouve dans la position de mesure, où il consomme beaucoup d'énergie, que pendant le temps de la mesure et que le reste du temps, l'appareil se trouve dans une position où il est beaucoup mieux isolé thermiquement et où il consomme peu.

Selon une autre caractéristique de l'invention, les moyens d'isolation comprennent au moins une paroi intermédiaire formant écran thermique disposé entre les parois chaudes et les parois froides, et des couches d'isolant disposées respectivement entre les parois froides et la paroi intermédiaire et entre la paroi intermédiaire et les parois chaudes. De plus, cette paroi intermédiaire est au moins partiellement souple, dans sa partie comprise entre l'extrémité de mesure du capteur et la paroi chaude de mesure, de façon à pouvoir se déformer lors du déplacement de cette paroi chaude de mesure.

De façon avantageuse, cette paroi intermédiaire souple est réalisée en polyester aluminisé ou non.

Cette paroi intermédiaire souple placée entre deux couches d'isolant peut ainsi se déformer lorsque la paroi chaude de mesure est écartée de l'extrémité de mesure du capteur et de sa paroi froide, de façon à ce que les couches d'isolant puissent occuper tout le volume existant d'une part, entre la paroi froide et cette paroi intermédiaire souple et d'autre part, entre cette paroi intermédiaire et la paroi chaude. Ainsi, on améliore encore l'isolation thermique. Au contraire, en position de mesure, cette paroi intermédiaire peut se rapprocher de la paroi froide en comprimant les couches d'isolant et en facilitant ainsi la mesure.

Selon un premier mode de réalisation, la paroi chaude de mesure à la forme d'un capuchon fileté intérieurement et conçu pour s'adapter sur l'extrémité avant de la paroi latérale de l'enceinte, la surface extérieure des parois latérales de l'enceinte étant filetée, ces filetages formant les moyens de déplacement de la paroi chaude.

De préférence, au moins un joint torique est placé dans un évidement prévu sur la surface extérieure des parois latérales de l'enceinte.

Ainsi, grâce à ce dispositif de capuchon fileté extrêmement simple à réaliser, le déplacement entre la position de mesure ou la position de repos se fera simplement en dévissant ou en revissant le capuchon sur la paroi latérale de l'enceinte.

L'invention sera mieux comprise à la lecture de la description suivante d'un mode de réalisation préférentiel donné à titre d'exemple illustratif, cette description étant faite en faisant référence aux dessins joints, dans lesquels :
- la figure 1 est une vue en coupe partielle d'un dispositif cryogénique selon l'art antérieur,
- la figure 2 est une vue en coupe partielle et détaillée d'un premier mode de réalisation du dispositif cryogénique selon l'invention, et
- la figure 3 est une vue en coupe d'un second mode de réalisation de l'invention.

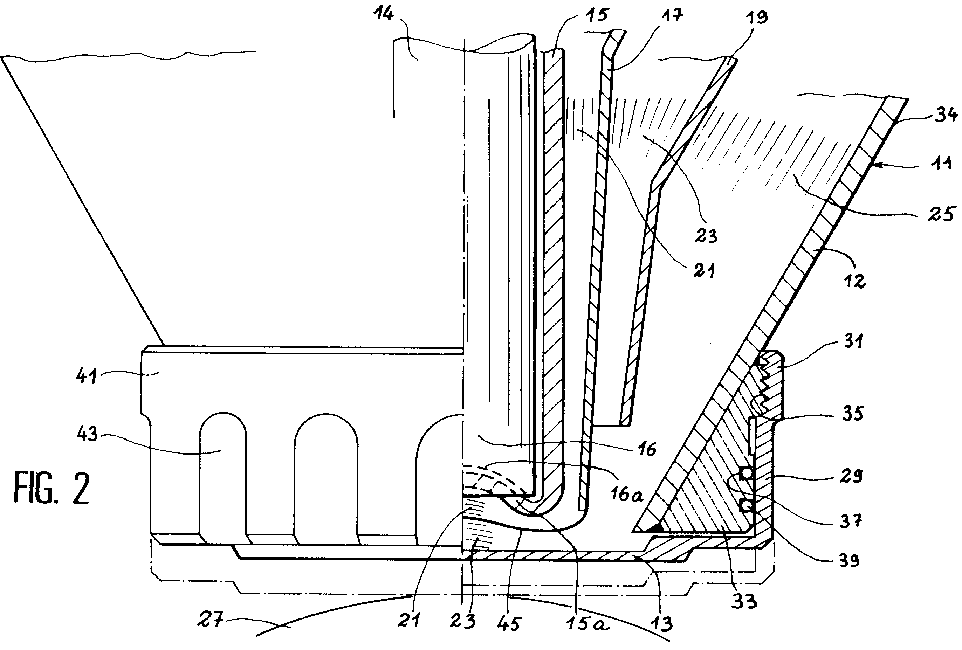

Le dispositif cryogénique pour capteur magnétique selon l'invention possède une structure assez semblable au dispositif de l'art antérieur, représenté en figure 1. Seule la partie basse de ce dispositif contenant le capteur magnétique a été modifiée comme cela est illustré en figure 2. En conséquence, les éléments du dispositif de l'invention présentant une forme identique aux éléments de l'art antérieur ne seront pas décrits plus en détail. Dans la suite de la description, le terme "avant" décrit les éléments ou parties d'éléments du dispositif dirigés vers le corps analysé, et inversement, pour le terme "arrière".

Le dispositif cryogénique comprend une enceinte définie par ses parois 11, dites parois chaudes, car en contact avec l'air ambiant. Ces parois sont réalisées dans un matériau composite amagnétique, du type fibre de verre et résine, par exemple. Plus précisément, cette enceinte comprend des parois latérales chaudes 12 et une paroi avant 13, dite paroi chaude de mesure puisqu'elle est dirigée vers le corps à analyser. Cette paroi chaude de mesure 13 est généralement sensiblement plane. Le dispositif comprend en outre un réservoir de liquide cryogénique (non représenté en figure 2) et un capteur magnétique 14 entouré de parois froides 15. Ce capteur présente une extrémité avant de mesure 16 dont la paroi avant 16a est concave. La partie avant 15a de la paroi froide 15 est également concave.

La partie avant de l'enceinte présente une forme tronconique. Toutefois, cette caractéristique n'est pas limitative de l'invention et l'on pourrait également envisager d'avoir une enceinte avec des parois latérales 11 cylindriques.

Deux parois intermédiaires 17 et 19 formant écran thermique sont disposées entre la paroi froide 15 et la paroi chaude latérale 12. Elles ont pour rôle de limiter les pertes thermiques entre ces deux parois. Ces parois intermédiaires sont identiques à celles de l'art antérieur. Elles sont généralement réalisées en fibre de verre et en résine et parfois même aluminisées. La paroi 17 se trouvant entre les parois 15 et 19 se termine sensiblement à la même hauteur que la partie avant 15a de la paroi froide 15, tandis que la paroi 19 est en retrait. On prévoit également de déposer entre ces différentes parois 15, 17, 19 et 11 des couches d'isolant référencées ci-après, respectivement 21, 23 et 25. Ces couches d'isolant sont réalisées par exemple dans des films de polyester d'une épaisseur d'environ 0,1 mm et connus sous la marque déposée MYLAR. Elles peuvent également être réalisées dans des films de polyester aluminisé. A titre d'exemple purement illustratif, la couche 21 peut comprendre une dizaine de pellicules superposées, la couche 23 entre vingt et trente pellicules et la couche 25 une trentaine. Ces couches sont disposées avec une densité de une pellicule par millimètre. L'isolant renforce l'action des parois intermédiaires 17 et 19. On pourrait également prévoir un nombre de parois intermédiaires différent.

Selon les caractéristiques de l'invention, la paroi chaude de mesure 13 qui vient au contact du corps 27 à examiner (généralement le corps humain), est munie de moyens de déplacement permettant de la déplacer entre une position de mesure dans laquelle elle est proche de l'extrémité de mesure 16 du capteur et de sa paroi froide avant 15a (position représentée en traits pleins) et une position de repos dans laquelle elle est éloignée de cette paroi froide avant (position représentée en traits mixtes).

Un premier mode de réalisation de ces moyens de déplacement est illustré en figure 2. La paroi chaude de mesure 13 présente un rebord cylindrique 29 fileté (référence 31) sur sa surface intérieure. Cette paroi chaude de mesure 13 présente donc la forme générale d'un capuchon conçu pour s'adapter sur l'extrémité avant de la paroi latérale 12 de l'enceinte. De façon avantageuse, ce capuchon est réalisé dans un matériau amagnétique à faible coefficient de frottement, tel qu'une résine synthétique fabriquée par condensation de l'hexaméthylènediamine avec l'acide adipique et connue sous le nom de Nylon 66 (marque déposée). De préférence, sa surface intérieure est métallisée afin de limiter le rayonnement.

Une pièce 33 formant vis est collée sur la surface extérieure 34 de la paroi latérale 12. Cette pièce formant vis 33 présente en coupe, une forme triangulaire. En d'autres termes, elle présente un orifice central tronconique. Elle permet de rattraper l'inclinaison de la paroi latérale 12 et de pouvoir y visser le capuchon 13, 29. Dans un autre mode de réalisation non représenté, on peut supprimer cette pièce formant vis 33 et modifier les parois latérales 12 de façon qu'elles soient cylindriques, que leur surface extérieure soit filetée et qu'elles présentent un évidement pour recevoir un joint torique. Cette partie formant vis 33 est également réalisée dans un matériau à faible coefficient de frottement du type Nylon 66 (marque déposée). Cette pièce formant vis 33 présente uniquement dans sa partie arrière un filetage 35 placé en vis-à-vis du filetage 31 du capuchon.

En outre, cette pièce formant vis 33 présente au moins un évidement 37 périphérique annulaire (ici deux sont représentés), destiné à recevoir un joint torique 39 formant joint dynamique et assurant l'étanchéité. Ce joint 39 est réalisé par exemple en caoutchouc artificiel tel qu'un copolymère butadiène-nitrile acrylique connu sous le nom de marque déposée Perbunan ou un polymère fluoré connu sous le nom de marque déposée Viton.

En outre, et comme illustré dans la partie gauche de !a figure 2, le capuchon présente sur la surface extérieure 41 du rebord cylindrique 29 des cannelures 43 facilitant la préhension de ce capuchon.

La paroi intermédiaire 17 présente, contrairement à l'art antérieur, une extrémité avant souple 45 réalisée de préférence en polyester (par exemple en MYLAR : marque déposée) aluminisé ou non. Cette paroi 45 est collée à l'extrémité avant de la paroi intermédiaire 17.

Cette paroi souple 45 peut se déformer de façon à suivre les mouvements de la paroi chaude de mesure 13. Ainsi, lorsque la paroi chaude de mesure 13 est en position de mesure, comme cela est représenté en traits pleins en figure 2, c'est-à-dire au voisinage de la paroi froide avant 15a, la paroi souple 45 a tendance à se replier vers l'intérieur de l'enceinte. Les formes concaves de la paroi avant 16a du capteur et de la partie avant 15a de la paroi froide 15 permettent de limiter la compression des couches d'isolant 21 se trouvant dans la zone de mesure. Au contraire, lorsque la paroi chaude de mesure est écartée de la paroi froide 15 après avoir été dévissée légèrement, la paroi souple 45 se détend vers l'avant de la paroi et les couches d'isolant 21 et 23 peuvent occuper un volume plus important en assurant ainsi une meilleure étanchéité thermique.

Les moyens de déplacement permettent d'écarter la paroi chaude de mesure 13 d'une quinzaine de millimètres de la paroi froide 15. Ceci est suffisant pour réaliser une isolation importante. L'autonomie du dispositif qui était de 2 jours passe à 8 jours.

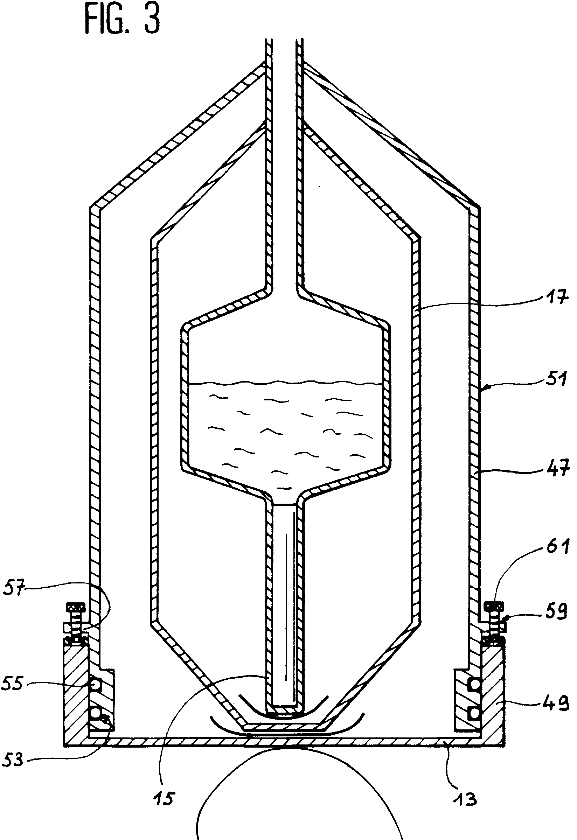

La figure 3 illustre un second mode de réalisation des moyens de déplacement de la paroi chaude de mesure 13 selon l'invention. Dans ce cas, l'enceinte présente des parois latérales 47 cylindriques. La paroi chaude de mesure 13 est également munie d'un rebord latéral cylindrique 49 entourant la surface extérieure 51 de la paroi latérale 47. En outre, la surface extérieure 51 présente au moins un logement périphérique 53 (ici deux) destiné à recevoir au moins un joint torique dynamique 55. On notera que la partie souple 45 de la paroi intermédiaire 17, n'a pas été représentée sur cette figure 3, afin de simplifier celle-ci. Toutefois, il est bien évident que cette paroi intermédiaire 17 pourrait être réalisée comme en figure 2.

La paroi latérale 47 est en outre munie d'au moins un profilé 57 rectiligne mince s'étendant radialement vers l'extérieur, sensiblement orthogonalement à sa surface extérieure 51. Ce profilé 57 présente un orifice taraudé 59. Sur la figure 3, seuls deux de ces profilés 57 ont été représentés, mais il est également possible d'en avoir un nombre supérieur à deux. Une vis 61 est placé dans chaque orifice 59. Cette vis 61 et le profilé 57 constituent les moyens de déplacement de la paroi chaude de mesure 13.

En effet, lorsque l'utilisateur souhaite écarter cette paroi 13, de la paroi froide 15, il visse les vis 61 dont les extrémités avant viennent en butée contre l'extrémité arrière du rebord 49, ce qui a pour effet de déplacer l'ensemble de la paroi chaude de mesure 13. Les têtes des vis 61 constituent des butées de fin de course. Les joints dynamiques 55 permettent d'assurer que le déplacement de la paroi de mesure 13 est étanche. Inversement, lorsque l'utilisateur souhaite mettre le dispositif cryogénique en position de mesure, il dévisse les vis 61 jusqu'à les amener en position arrière et la paroi chaude de mesure 13 remonte à l'encontre de la force de freinage exercée par les joints toriques 55, du fait de la dépression existant à l'intérieur de l'enceinte.

Il est également possible d'utiliser d'autres moyens de déplacement de la paroi chaude de mesure tels que des glissières ou des soufflets, sans pour autant sortir du cadre de l'invention.

## Revendications

1. Dispositif cryogénique pour capteur magnétique comprenant une enceinte définie par des parois (11) dites parois chaudes, à l'intérieur de laquelle sont disposés ledit capteur (14) et un réservoir de liquide cryogénique, ce capteur (14) étant entouré de parois refroidies par le liquide cryogénique, dites parois froides (15) et présentant une extrémité avant (16) de mesure placée en vis-à-vis d'une des parois chaudes de l'enceinte formant une paroi chaude de mesure (13), des moyens d'isolation étant prévus entre lesdites parois froides (15) et lesdites parois chaudes (11), caractérisé en ce que la paroi chaude de mesure (13) est munie de moyens de déplacement permettant de la déplacer entre une position de mesure dans laquelle elle est proche de l'extrémité avant de mesure (16) du capteur et de la paroi froide avant (15a) disposée en regard de cette extrémité (16) et une position de repos dans laquelle elle est éloignée de cette paroi froide avant.

2. Dispositif cryogénique selon la revendication 1, caractérisé en ce que les moyens d'isolation comprennent au moins une paroi intermédiaire (17, 19) formant écran thermique disposée entre les parois chaudes (11) et les parois froides (15) et des couches d'isolant (21, 23, 25) disposées respectivement entre les parois froides (15) et la paroi intermédiaire (17, 19) et entre la paroi intermédiaire (17, 19) et les parois chaudes (11).

3. Dispositif cryogénique selon la revendication 2, caractérisé en ce que cette paroi intermédiaire (17) est au moins partiellement souple dans sa partie (45) comprise entre l'extrémité de mesure (16) du capteur et la paroi chaude de mesure (13), de façon à pouvoir se déformer lors du déplacement de cette paroi chaude de mesure.

4. Dispositif cryogénique selon la revendication 3, caractérisé en ce que cette paroi intermédiaire souple (45) est réalisée dans un matériau choisi parmi le polyester ou le polyester aluminisé.

5. Dispositif cryogénique selon la revendication 3 ou 4, caractérisé en ce que la partie souple (45) de la paroi intermédiaire est collée sur l'extrémité avant de la paroi intermédiaire (17).

6. Dispositif cryogénique selon la revendication 1, caractérisé en ce que la paroi chaude de mesure a la forme d'un capuchon (13, 29) fileté (31) intérieurement et conçu pour s'adapter sur l'extrémité avant de la paroi latérale (12) de l'enceinte et en ce que la surface extérieure des parois latérales (12) de l'enceinte est filetée, ces filetages formant les moyens de déplacement de la paroi chaude.

7. Dispositif cryogénique selon la revendication 6, caractérisé en ce qu'au moins un joint torique (39) est placé dans un évidement (37) prévu sur la surface extérieure des parois latérales (12) de l'enceinte.

8. Dispositif cryogénique selon la revendication 6 ou 7, caractérisé en ce qu'une pièce (33) formant vis présentant un orifice central tronconique est collée sur la surface extérieure (34) de la paroi latérale (12) tronconique, en ce que cette pièce (33) est munie d'un filetage (35) destiné à coopérer avec le filetage (31) du capuchon (13, 29) et en ce que cette pièce (33) présente au moins un évidement (37) destiné à recevoir un joint torique (39).

9. Dispositif cryogénique selon la revendication 1, caractérisé en ce que les parois latérales (47) de l'enceinte sont cylindriques et présentent sur leur surface extérieure (51) au moins un logement périphérique (53) destiné à recevoir au moins un joint dynamique (35) et en ce que la paroi chaude de mesure (13) est munie d'un rebord latéral cylindrique (49) entourant ladite surface extérieure (51) et coopèrant avec le joint dynamique (55).

10. Dispositif cryogénique selon la revendication 9, caractérisé en ce que les moyens de déplacement sont constitués par au moins une vis (61) coopérant avec un profilé (57) muni d'un orifice taraudé (59), ce profilé (57) faisant saillie de la surface extérieure (51) des parois latérales (47) de l'enceinte et en ce que l'extrémité de la vis (61) vient en butée contre l'extrémité du rebord latéral cylindrique (49) de la paroi chaude de mesure (13).

11. Dispositif cryogénique selon la revendication 1, caractérisé en ce que l'extrémité avant (16) du capteur (14) présente une paroi avant (16a) concave et en ce que la paroi froide avant (15a) est également concave.
